Europäisches Patentamt

European Patent Office

Office européen des brevets

(11) Veröffentlichungsnummer: **0 262 622 B1**

## (12) EUROPÄISCHE PATENTSCHRIFT

(45) Veröffentlichungstag der Patentschrift: **22.05.91**

(51) Int. Cl.⁵: **H05K 5/06**, H01H 50/02

(21) Anmeldenummer: **87114067.9**

(22) Anmeldetag: **25.09.87**

(54) **Gehäuse für ein elektrisches Bauelement, insbesondere ein Relais, und Verfahren zur Abdichtung eines solchen.**

(30) Priorität: 30.09.86 DE 3633304
25.08.87 DE 8711522 U

(43) Veröffentlichungstag der Anmeldung:
06.04.88 Patentblatt 88/14

(45) Bekanntmachung des Hinweises auf die
Patenterteilung:
22.05.91 Patentblatt 91/21

(84) Benannte Vertragsstaaten:
**CH DE FR GB LI**

(56) Entgegenhaltungen:
**EP-A- 0 127 152**
**DE-U- 8 124 847**
**GB-A- 2 009 532**
**GB-A- 2 080 628**

(73) Patentinhaber: **Siemens Aktiengesellschaft**
**Wittelsbacherplatz 2**
**W-8000 München 2(DE)**

(72) Erfinder: **Hendel, Horst, Dipl.-Ing.**
**Kruckenbergstrasse 42**
**W-1000 Berlin 42(DE)**

**Beschreibung**

Die Erfindung betrifft ein Gehäuse für ein elektrisches Bauelement, insbesondere ein Relais oder ein damit vergleichbares elektromechanisches Bauelement, mit einer einen hohlen Innenraum abschließenden Gehäusewand, welche abzudichtende Stellen, wie Durchbrüche und Spalte im Bereich von Anschlußstiften und/oder an ihrem Rand, aufweist, wobei die Gehäusewand Führungselemente zur Förderung von Vergußmasse von einer oder mehreren Dosierstellen zu den abzudichtenden Stellen aufweist. Außerdem betrifft die Erfindung ein Verfahren zur Abdichtung eines derartigen Gehäuses.

Bei bekannten Gehäusen dieser Art, wie sie beispielsweise aus der DE-A-30 26 371 bekannt sind, erfolgt die Verteilung der Vergußmasse durch die Kapillarwirkung von Kapillarkanälen bzw. durch die Schwerkraft aus vertieft eingearbeiteten Dosierstellen über entsprechende Kanäle, welche in die betreffende Gehäusewand, in der Regel in eine Bodenplatte, eingearbeitet sind. Das bedeutet aber eine Schwächung der jeweiligen Bodenplatte, die üblicherweise ohnehin nur wenige Zehntel Millimeter stark ist, so daß die Dicke der Bodenplatte von vornherein um die Tiefe der Kapillarkanäle und Dosierstellen vergrößert werden muß, um die mechanische Stabilität zu gewährleisten. Weiterhin erfordert die Herstellung solcher Kapillarkanäle in Gehäusewänden einen verhältnismäßig hohen Aufwand insofern, als die hierzu erforderlichen erhabenen Stege im Spritzwerkzeug einen verhältnismäßig hohen Arbeitsaufwand benötigen. Darüber hinaus führen Kapillarkanäle zumindest dann nicht zu einer sicheren Abdichtung aller Gehäusedurchbrüche, wenn diese Durchbrüche verhältnismäßig weit sind und die Kapillarkanäle an deren Rand enden.

Aufgabe der Erfindung ist es, ein Gehäuse der eingangs genannten Art und das Verfahren zu dessen Abdichtung mittels Kapillarverteilung von Vergußmasse in der Wirkung zu verbessern, dabei aber das Gehäuse selbst und dessen Herstellung möglichst einfach zu halten, insbesondere auch eine nachteilige Vergrößerung der Bauhöhe zu vermeiden.

Erfindungsgemäß wird diese Aufgabe dadurch gelöst, daß auf der Gehäusewand Verteilungsrippen vorgesehen sind, welche sich von der Dosierstelle bzw. den Dosierstellen zu den Abdichtstellen erstrecken und zumindest an einer Seite eine scharfe Innenkante mit der Gehäusewand bilden.

Bei dem erfindungsgemäßen Gehäuse wird die Kapillarwirkung nicht durch eingesenkte Kanäle, sondern durch die scharfe Innenkante zwischen der jeweiligen Verteilungsrippe und der Oberfläche der Gehäusewand erzeugt. Der Winkel zwischen der jeweiligen Verteilungsrippe und der Oberfläche der Gehäusewand beträgt in der einfachsten Ausführungsform etwa 90°, und er sollte nicht viel größer sein, da die Kapillarwirkung sich mit zunehmendem Winkel verschlechtert. Wünschenswert wäre sogar ein Winkel, der kleiner ist als 90°, was etwa durch ein Schwalbenschwanz-Profil der Verteilungsrippen erreicht werden könnte. Dies ist jedoch fertigungstechnisch nur äußerst schwierig zu realisieren.

Ein weiterer Vorteil der Erfindung besteht darin, daß im Spritzwerkzeug für die Erzeugung der Verteilungsrippen lediglich gerade Nuten eingeschnitten zu werden brauchen, so daß also auch die Herstellung des Gehäuses insgesamt vereinfacht wird. Außerdem bedeuten die Verteilungsrippen, obwohl sie an der Außenseite auf die Gehäusewand aufgebracht sind, im Gegensatz zu den Kapillarkanälen in der Praxis keine Vergrößerung der Gehäuseabmessungen, da an der Anschlußseite eines Bauelementes, wie eines Relais, in der Regel ohnehin Abstandsnasen oder sonstige vorstehende Rippen vorgesehen werden, um beim Einlöten auf Leiterplatten sowie beim nachfolgenden Reinigen einen Abzug der Lötdämpfe und der Reinigungsmittel zu ermöglichen. Die erfindungsgemäß vorgesehenen Verteilungsrippen erreichen bei weitem nicht die Höhe solcher Abstandsnasen und können allenfalls selbst zusätzlich die Funktion solcher Abstandselemente erfüllen. Beispielsweise kann bei Verteilungsrippen mit einer Höhe von etwa 0,1 bis 0,2 mm bereits eine gute Verteilung von Vergußmasse erzielt werden.

Wenn die Gehäusedurchbrüche einen verhältnismäßig großen Durchmesser aufweisen und ihr Rand nicht immer unmittelbar etwa an einem Anschlußstift anliegt, so kann zur Verbesserung der Kapillarförderung vorgesehen sein, daß diese Gehäusedurchbrüche nach außen trichterförmig erweitert sind und daß sich die Verteilungsrippen über die Trichterfläche in den Durchbruch hinein erstrecken. Im Gegensatz zu Kapillarkanälen, die in jedem Fall am Rand eines solchen Durchbruches enden würden, läßt sich auf diese Weise die Kapillarförderung über den Trichter in den jeweiligen Durchbruch hinein verlängern. Es ist auch möglich, die über eine Verteilungsrippe in einen Durchbruch hineingeführte Vergußmasse an einer anderen Stelle dieses Durchbruchs über eine weitere Verteilungsrippe wieder aus diesem heraus zu einem weiteren Durchbruch oder Gehäusespalt weiterzuleiten.

Bei der Abdichtung von Gehäusen mit Vergußmasse ist es wichtig, in alle abzudichtenden Durchbrüche und Spalte genügend Vergußmasse hineinzubefördern, dabei aber zu verhindern, daß die Vergußmasse in das Gehäuseinnere hineinläuft und dort Kontakte oder sonstige bewegliche Elemente verklebt. Es ist deshalb zweckmäßig, daß die Durchbrüche und Spalte an der den Verteilungsrippen zugewandten Seite einen abgerundeten Rand mit einem möglichst großen Radius und an der gegenüberliegenden Seite, also an der Innenseite des Gehäuses, einen scharfkantigen Rand aufweisen. Auf diese Weise wird gewährleistet, daß die Vergußmasse entlang der jeweiligen Verteilungsrippe über den abgerundeten Rand in den trichterförmigen Durchbruch hineingelangt, jedoch an der gegenüberliegenden Seite der Gehäusewand nicht über den scharfkantigen Rand, der als Kapillarsperre wirkt, in das Gehäuseinnere weiterläuft.

Bei der Herstellung und Abdichtung eines Bauelementgehäuses der oben erwähnten Art werden die Verteilungsrippen beim Gießen oder Spritzen der betreffenden Gehäusewand, also in der Regel einer Bodenplatte oder Deckplatte, mit angeformt, und nach der Montage des Bauelementes in dem Gehäuse wird die Vergußmasse in Tropfenform auf die Verteilungsrippen aufgebracht. Zweckmäßigerweise werden die Verteilungsrippen so angeordnet, daß sie strahlenförmig von jeweils einer Dosierstelle zu den abzudichtenden Stellen verlaufen. Die Dosierstellen brauchen aber nicht, wie bei der herkömmlichen Technik mit Kapillarkanälen üblich, in Form von Vertiefungen in die Gehäusewand eingeformt zu werden. Vielmehr genügt es, wenn die Vergußmasse unmittelbar auf die Verteilungsrippen aufgetropft wird, ohne daß eine eigens ausgeformte Dosierstelle vorhanden ist. Dabei ist es auch durchaus möglich, bei einer quer über die Gehäusewand verlaufenden Verteilungsrippe die Vergußmasse irgendwo an einer zweckmäßigen Stelle auf die Verteilungsrippe aufzutropfen, von wo aus sie dann nach beiden Seiten durch die Kapillarwirkung weiter verteilt werden kann.

Die Erfindung wird nachfolgend an zwei Ausführungsbeispielen anhand der Zeichnung näher erläutert. Es zeigt

FIG 1      eine Ansicht auf die Anschlußseite oder Bodenseite eines Relais,

FIG 2      einen Detailausschnitt der Bodenseite des Relais gemäß FIG 1 in perspektivischer Darstellung.

FIG 3      eine Weiterbildung der Bodenseite

FIG 4      in teils geschnittener Darstellung einen vergrößerten Ausschnitt aus FIG 3.

Das in der Zeichnung gezeigte Relais, von dem im wesentlichen nur die Bodenseite zu sehen ist, besitzt ein Gehäuse mit einer Gehäusekappe 1 und einer Bodenplatte 2, wobei der sonstige interne Aufbau des Relais, der für die Erfindung ohne Bedeutung ist, auch nicht dargestellt ist. Das Relais besitzt Anschlußstifte 3 mit rundem Querschnitt und Anschlußstifte 4 mit rechteckigem Quer schnitt, die jeweils in angepaßten runden Durchbrüchen 5 bzw. rechteckigen Durchbrüchen 6 der Bodenplatte 2 aus dem Gehäuseinneren nach außen zur Anschlußseite des Relais geführt sind. Außerdem besteht ein Randspalt 7 zwischen der Bodenplatte 2 und dem Rand 1a der Gehäusekappe 1. Dieser umlaufende Randspalt 7 soll ebenso wie die erwähnten Durchbrüche 5 und 6 der Anschlußstifte mittels Vergußmasse abgedichtet werden.

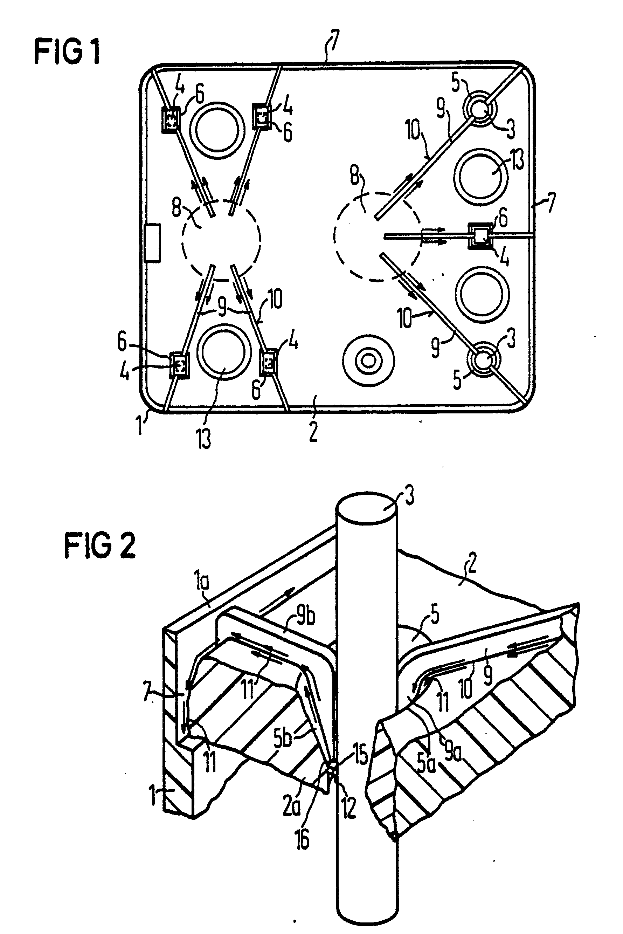

Da ein unmittelbares Einbringen der Vergußmasse in die einzelnen Durchbrüche 5, 6 und Spalte 7 umständlich wäre und insbesondere die Gefahr einer Verunreinigung der Anschlußstifte mit isolierender Vergußmasse mit sich brächte, werden Vergußmasse-Tropfen 8 an leicht zugänglichen Dosierstellen, die allerdings nicht besonders ausgeformt sind, auf die Bodenplatte 2 aufgebracht. Von diesen Dosierstellen aus gehen strahlenförmig jeweils Verteilungsrippen 9 ab, die zu den einzelnen Gehäusen 5 und 6 bzw. zum Randspalt 7 führen. Diese Verteilungsrippen 9 bilden eine scharfe Innenkante 10 jeweils gegenüber der Oberfläche der Bodenplatte 2. Sie können bei einem Kleinrelais beispielsweise eine Höhe in der Größenordnung von 0,1 bis 0,2 mm aufweisen. Entlang diesen Kanten verteilt sich die mit den Tropfen 8 aufgebrachte Vergußmasse mittels Kapillarwirkung an die gewünschten Stellen, wobei in den FIG 1 und 2 jeweils mit Pfeilen die Fließrichtung der Vergußmasse dargestellt ist. Bei dem gezeigten Ausführungsbeispiel führen die Kriechwege 11 jeweils von einer Dosierstelle bzw. von einem Tropfen 8 über die jeweiligen Verteilungsrippen 9 zu den einzelnen Durchbrüchen 5 und 6 mit den zugehörigen Anschlußstiften 3 und 4 und dann weiter von diesen Durchbrüchen 5 und 6 hin zum Randspalt 7. In dem Randspalt verteilt sich die Vergußmasse dann mittels der dort vorhandenen, an sich bekannten Kapillarwirkung. Abweichend von der in FIG 1 dargestellten Ausführungsform könnte natürlich auch eine Verteilungsrippe 9 unmittelbar von einem Tropfen 8 zum Randspalt 7 geführt sein.

In der FIG 2 ist in vergrößerter Darstellung die besondere Ausgestaltung von Verteilungsrippen 9 im Bereich eines Durchbruchs 5 bzw. des Randspalts 7 gezeigt. Um eine gute Kapillarführung der Vergußmasse in den Durchbruch 5 hinein zu gewährleisten, ist dieser Durchbruch 5 trichterförmig gestaltet, wobei der zur Außenseite weisende Rand 5a mit einem möglichst großen Radius ausgeformt ist. Über diesen abgerundeten Rand 5a führt die Verteilungsrippe 9 mit ihrem abgebogenen Abschnitt 9a. Auf diese Weise erstreckt sich die zur Kapillarwirkung erforderliche scharfe Innenkante zwischen der Verteilungsrippe 9 und der Bodenplatte 2 bis in den trichterförmigen Durchbruch hinein, wobei der abgerundete Rand 5a den Fluß nicht behindert. Scharfe Außenkanten dagegen stellen eine Kapillarsperre dar. Eine solche ist beispielsweise an der Innenoberfläche der Bodenplatte erforderlich, um ein Weiterfließen der Vergußmasse aus dem Durchbruch 5 in das Gehäuseinnere zu verhindern. Zu diesem Zweck ist eine scharfe Kante 12 im Bereich der Innenseite 2a der Bodenplatte 2 ausgebildet, die somit den Kriechweg für die Vergußmasse unterbricht und ein Weiterfließen in das Gehäuseinnere verhindert.

Aus FIG 2 ist auch zu ersehen, daß die Vergußmasse, die über die Verteilungsrippe 9 und deren abgebogenen Abschnitt 9a in den Durchbruch 5 hineinfließt, über die weitere Verteilungsrippe 9b auch aus dem Durchbruch 5 wieder heraus weiter zum Randspalt 7 geführt wird. Durch die Kapillarwirkung an der scharfen Innenkante 10 kann dabei auch ein gewisser Höhenunterschied überwunden werden.

In FIG 2 ist die Kante 12 an der Unterseite einer dünnen Trennwand 15 gezeigt, welche sich mehr oder weniger gut an den Anschlußstift 3 anschmiegt. Diese Trennwand kann zweckmäßigerweise in der Trennebene des Spritzwerkzeuges liegen und unter Umständen auch als geschlossene Spritzhaut den Durchbruch 5 verschließen, wenn dieser Durchbruch bei einer geringeren Kontaktbestückung des Relais keinen Anschlußstift aufzunehmen hat. Wie in FIG 2 zu sehen ist, endet die Verteilungsrippe 9b auf der Oberseite der Trennwand unter Bildung einer scharfen Innenkante, außerdem bildet die Trichterfläche 5b mit der Trennwand eine umlaufende scharfe Innenkante 16. Damit wird die Vergußmasse, die entlang einer Verteilungsrippe 9 in den trichterförmigen Durchbruch 5 gelangt, durch Kapillarwirkung entlang der Innenkante 16 über den ganzen Umfang des Durchbruchs 5 verteilt, selbst wenn kein Anschlußstift 3 vorhanden ist. Auch in diesem Fall kann somit die Vergußmasse von einer Verteilungsrippe 9 über den Durchbruch 5 zu der Verteilungsrippe 9b und aus dem Durchbruch 5 heraus geleitet werden. Der Durchbruch selbst wird ebenfalls in jedem Fall abgedichtet.

Durch Anbringen von mehreren Verteilungsrippen im engen Abstand parallel zueinander kann die Verteilungskapazität für die Vergußmasse an die jeweiligen Erfordernisse angepaßt werden. Von Bedeutung für eine gleichförmige Verteilung der Vergußmasse ist unter Umständen das Anbringen von geeigneten Kriechsperren in kritischen Bereichen, wie mit der Kante 12 beispielsweise gezeigt. Durch solche Kriechsperren muß vor allem erreicht werden, daß ein ungewollter partieller Entzug von Vergußmasse verhindert wird, der die Einheitlichkeit des Kapillargefälles stören und somit eine gleichförmige Verteilung beeinträchtigen würde. Ganz allgemein sei nochmal erwähnt, daß gute Kriechsperren durch scharfe Außenkanten gebildet werden, die ihre volle Wirksamkeit aber nur entfalten, wenn sie in sich geschlossen sind und nicht an scharfe Innenkanten, die wiederum eine gute Kapillarwirkung haben, angrenzen.

Zu FIG 1 sei noch erwähnt, daß dort auf der Bodenplatte zusätzliche Abstandsnoppen 13 vorgesehen sind, die beim Aufsetzen des Relais auf eine Leiterplatte das Abziehen von Lötdämpfen ermöglichen. Diese Abstandsnoppen 13 sind in der Regel höher als die Verteilungsrippen 9, so daß letztere keine wirksame Vergrößerung der Relaishöhe verursachen. Im übrigen wird die Vergußmasse in bekannter Weise ausgehärtet. In FIG 1 ist außerdem ein Lüftungsloch angedeutet, welches nach dem Abdichten des Gehäuses und nach dem Aushärten der Vergußmasse in üblicher Weise verschlossen werden kann.

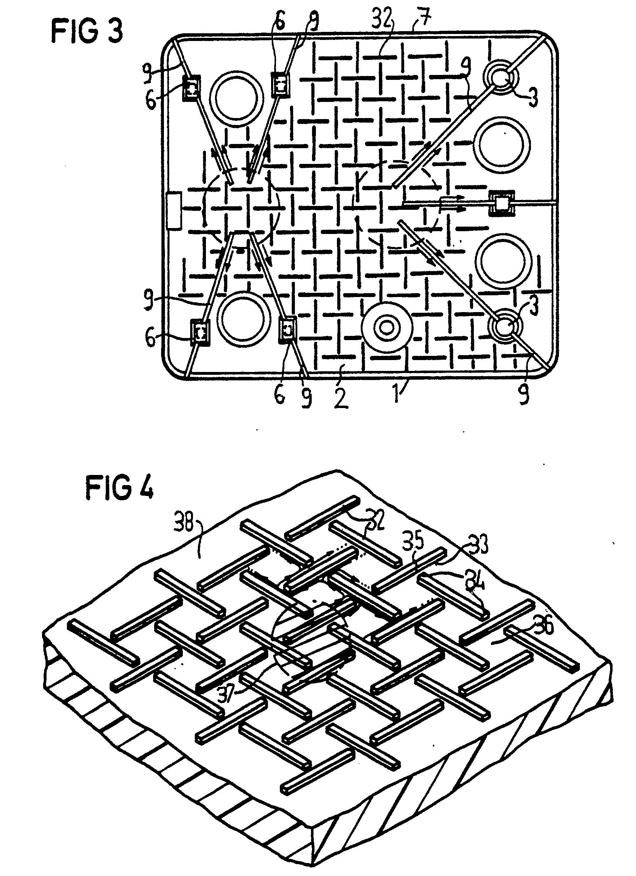

Die in Fig 3 dargestellte Bodenplatte 2 besitzt Verteilungsrippen 9, welche eine flüssige Masse an abzudichtende Durchbrüche 6 und einen ebenfalls umlaufenden Randspalt 7 weiterleiten. Über die gesamte Oberfläche sind rasterartig weitere Rippen 32 verteilt.

In Fig.4 ist ein vergrößerter Ausschnitt der Bodenplatte 2 mit den daran angeformten Rippen 32 dargestellt. Die Rippen 32 besitzen dabei zur Bodenplatte 2 einen scharfkantigen Übergang 33. Mindestens ein Ende 34 der Rippe ist dabei auf die Seitenwand 35 einer benachbarten Rippe 32 ausgerichtet. Zwischen dem Ende 34 und der Seitenwand 35 verbleibt lediglich ein kleiner Spalt 36. An einer Dosierstelle 37 wird eine flüssige Masse aufgebracht. Diese Masse kriecht infolge der Kapillarwirkung entlang der scharfkantigen Übergänge 33 bis an die Enden 34 der Rippen 32 und überwindet den Spalt 36 zur Seitenwand 35 der nächsten Rippe. Von dort aus verteilt sich die flüssige Masse in geschilderter Weise bis an den Rand der Benetzungszone 38. Die Breite des Spaltes 36 hängt dabei von der grundsätzlichen Benetzbarkeit des verwendeten Materials ab.

Bei dem gezeigten Ausführungsbeispiel sind die Rippen ca. 1,5 mm lang und ca. 0,1 mm hoch. In einer anderen Ausgestaltung ist es für den Fachmann naheliegend anstatt der Rippen andere Erhebungen z.B. Säulen mit quadratischem Querschnitt oder Noppen vorzusehen. Für die Benetzbarkeit ist dabei wichtig, daß eine scharfe Innenkante zwischen Erhebung und Gehäuseteil sowie ein geringer Abstand zwischen den Säulen vorhanden ist. Ebenso ist es denkbar die Säulen auf Noppen zu reduzieren.

## Ansprüche

1. Gehäuse für ein elektrisches Bauelement, insbesondere ein Relais, mit einer einen hohlen Innenraum abschließenden Gehäusewand (2), welche abzudichtende Stellen, wie Durchbrü-

che (5, 6) und Spalte (7) im Bereich von Anschlußstiften und/oder an ihrem Rand aufweist, wobei die Gehäusewand (2) Führungselemente zur Förderung von Vergußmasse (8) von einer oder mehreren Dosierstellen zu den abzudichtenden Stellen aufweist, **dadurch gekennzeichnet,** daß auf der Gehäusewand (2) Verteilungsrippen (9) vorgesehen sind, welche sich von der Dosierstelle bzw. den Dosierstellen zu den Abdichtstellen (5, 6, 7) erstrecken und zumindest an einer Seite eine scharfe Innenkante (10) mit der Gehäusewand (2) bilden.

2. Gehäuse nach Anspruch 1,
   **dadurch gekennzeichnet,**
   daß abzudichtende Gehäusedurchbrüche (5, 6) nach außen trichterförmig erweitert sind und daß sich die Verteilungsrippen (9) über die Trichterfläche in den jeweiligen Durchbruch (5, 6) hinein erstrecken.

3. Gehäuse nach Anspruch 2,
   **dadurch gekennzeichnet,**
   daß eine Verteilungsrippe (9) sich von einer Dosierstelle in einen ersten Gehäusedurchbruch (5) hinein erstreckt und daß eine weitere Verteilungsrippe (9b) aus dem ersten Durchbruch heraus zu einem weiteren Durchbruch oder zu einem Spalt (7) des Gehäuses führt.

4. Gehäuse nach einem der Ansprüche 1 bis 3,
   **dadurch gekennzeichnet,**
   daß die Durchbrüche (5, 6) und Spalte (7) an der den Verteilungsrippen entgegengesetzten Seite der Gehäusewand (2) zumindest in dem Bereich der Verteilungsrippen (9) einen abgerundeten Rand (5a) und an der entgegengesetzten Seite der Gehäusewand (2a) einen scharfkantigen Rand (12) aufweisen.

5. Gehäuse nach einem der Ansprüche 1 bis 4,
   **dadurch gekennzeichnet,**
   daß jeweils von einer Dosierstelle auf der Gehäusewand strahlenförmig mehrere Verteilungsrippen (9) auseinanderlaufen.

6. Gehäuse nach einem der Ansprüche 1 bis 5,
   **dadurch gekennzeichnet,**
   daß von einer Dosierstelle aus jeweils zwei oder mehr Verteilungsrippen parallel nebeneinander zu einer oder mehreren bestimmten abzudichtenden Stellen verlaufen.

7. Gehäuse nach einem der Ansprüche 1 bis 6, en Bauelementes,
   **dadurch gekennzeichnet,**
   daß Rippen (32) rasterartig auf einen zu benetzenden Bereich (38) der Gehäusewand (1) verteilt angeordnet sind und jeweils zwischen dem Ende (34) einer ersten Erhebungen und der Seitenwand (35) einer zweiten, zur ersten in etwa querverlaufenden Erhebung ein so kleiner Abstand vorgesehen ist, daß die flüssige Vergußmasse durch deren Oberflächenspannung an die nächste Erhebung herangesaugt wird.

8. Gehäuse nach einem der Ansprüche 1 bis 7,
   **gekennzeichnet**
   durch eine solche Anordnung der Erhebungen, daß die vom Kleber bzw. der Vergußmasse von der Dosierstelle (37) aus entlang der einzelnen Rippen (32) bis an den Rand der Benetzungszone (38) zurückgelegte Strecke in etwa gleich lang ist.

9. Verfahren zur Abdichtung eines elektrischen Bauelementes, mit einem Gehäuse nach einem der Ansprüche 1 bis 8,
   **dadurch gekennzeichnet,**
   daß bei der Herstellung der Gehäusewand (2) an deren Außenseite Verteilungsrippen (9) mit scharfen Innenkanten (19) gegenüber der Wandoberfläche angeformt werden und daß nach Abschluß der Montage die Verußmasse auf die Verteilungsrippen (9) aufgebracht und über diese zu den abzudichtenden Stellen befördert wird.

## Claims

1. Casing for an electrical component, preferably a relay, having a casing wall (2) which seals a hollow inner space and which has points to be sealed, such as apertures (5, 6) and gaps (7), in the region of connection pins and/or on its edge, the casing wall (2) having guide elements for transporting sealing compound (8) from one or more metering points to the points to be sealed, characterised in that distribution ribs (9) are provided on the casing wall (2) which extend from the metering point or the metering points to the sealing points (5, 6, 7) and form at least on one side a sharp inner edge (10) with the casing wall (2).

2. Casing according to Claim 1, characterised in that casing apertures (5, 6) to be sealed are extended outwards in a funnel shape, and in that the distribution ribs (9) extend over the funnel surface into the respective aperture (5, 6).

3. Casing according to Claim 2, characterised in that a distribution rib (9) extends from a metering point into a first casing aperture (5), and in that a further distribution rib (9b) leads out of the first aperture to a further aperture or to a gap (7) of the casing.

4. Casing according to one of Claims 1 to 3, characterised in that the apertures (5, 6) and gaps (7) on the side of the casing wall (2) opposite the distribution ribs have at least in the region of the distribution ribs (9) a rounded-off edge (5a) and on the opposite side of the casing wall (2a) a sharply formed edge (12).

5. Casing according to one of Claims 1 to 4, characterised in that in each case a plurality of distribution ribs (9) radiate outwards from one metering point on the casing wall.

6. Casing according to one of Claims 1 to 5, characterised in that in each case two or more distribution ribs extend in parallel next to one another from a metering point to one or more specified points to be sealed.

7. Casing according to one of Claims 1 to 6, characterised in that ribs (32) are arranged distributed in a grid-like manner over a region (38) of the casing wall (1) to be wetted and in each case a spacing is provided between the end (34) of a first elevation and the side wall (34) of a second elevation extending approximately transversely with respect to the first, which spacing is so small that the liquid sealing compound is drawn by its surface tension onto the next elevation.

8. Casing according to one of Claims 1 to 7, characterised by such an arrangement of the elevations that the distance travelled by the adhesive or by the sealing compound from the metering point (37) along the individual ribs (32) to the edge of the wetting zone (38) is of approximately equal length.

9. Method for sealing an electrical component having a casing according to one of Claims 1 to 8, characterised in that, during the manufacture of the casing wall (2), distribution ribs (9) with sharp inner edges (19) in respect of the wall surface are formed onto the outside of said casing wall, and in that after the assembly is terminated the sealing compound is applied to the distribution ribs (9) and is transported by means of said ribs to the points to be sealed.

**Revendications**

1. Boîtier pour un composant électrique, en particulier un relais, comportant une paroi de boîtier (2) qui ferme une chambre intérieure creuse et qui comporte, dans la zone de chevilles de raccordement et/ou au niveau de son bord, des emplacements à rendre étanches, tels que des ouvertures (5,6) et fentes (7), la paroi de boîtier (2) comportant des éléments de guidage pour le passage d'une masse de coulée (8) depuis un ou plusieurs emplacements de dosage jusqu'aux emplacements à rendre étanches, caractérisé par le fait que sur la paroi de boîtier (2) sont prévues des nervures de répartition (9) qui s'étendent d'un emplacement de dosage ou des emplacements de dosage aux emplacement à rendre étanches (5,6,7) et qui forment, au moins en un emplacement, une arête intérieure vive (10) avec la paroi de boîtier (2).

2. Boîtier selon la revendication 1, caractérisé par le fait que les ouvertures (5,6) du boîtier, qui sont à rendre étanches, sont élargies coniquement vers l'extérieure, et que les nervures de répartition (9) s'étendent sur la surface conique pour déboucher dans les ouvertures correspondantes (5,6).

3. Boîtier selon la revendication 2, caractérisé par le fait qu'un nervure de répartition (9) s'étend depuis en premier emplacement de dosage jusque dans une première ouverture de boîtier (5), et qu'une seconde nervure de répartition (9b) mène de la première ouverture à une seconde ouverture ou à une fente (7) du boîtier.

4. Boîtier selon l'une des revendications 1 à 3, caractérisé par le fait que les ouvertures (5,6), et la fente (7) présentent, sur le côté de la paroi de boîtier (2) qui est opposée aux nervures de répartition, au moins dans la zone des nervures de répartition (9), un bord arrondi (5a) et du côté opposé de la paroi boîtier (2a) un bord (12) à arête vive.

5. Boîtier selon l'une des revendications 1 à 4, caractérisé par le fait qu'à partir d'un emplacement de dosage, plusieurs nervures de répartition (9) s'écartent en elles, sur la paroi de boîtier, en forme d'éventail.

6. Boîtier selon l'une des revendications 1 à 5, caractérisé par le fait qu'à partir d'un emplacement de dosage, deux ou plusieurs nervures de répartition s'étendent parallèlement entre elles en direction d'un ou de plusieurs emplacements déterminés à étanchéifier.

7. Boîtier selon l'une des revendications 1 à 6, caractérisé par le fait que les nervures (32) sont réparties suivant une trame sur une zone (38) de la paroi boîtier (1) qui est à mouiller, et qu'entre l'extrémité (34) d'une première nervure et la paroi latérale (35) d'une seconde nervure qui s'étend à peu près transversalement par rapport à la première, il est prévu un écartement tellement faible que la masse de coulée liquide est aspirée, par sa tension superficielle, en direction de la nervure suivante.

8. Boîtier selon l'une des revendications 1 à 7, caractérisé par un agencement tel des nervures que le chemin parcouru par l'adhésif ou par la masse de coulée depuis l'emplacement de dosage (37), et le long des nervures individuelles (32), jusqu'au bord de la zone de mouillage, est sensiblement constante.

9. Procédé pour rendre étanche un composant électrique avec un boîtier selon l'une des revendications 1 à 8, caractérisé par le fait que lors de la fabrication de la paroi de boîtier (2) on conforme sur le côté extérieur de celle-ci, des nervures de répartition (9) à arêtes intérieures vives (19) par rapport à la surface de la paroi, et qu'après la fin du montage, la masse de coulée est déposée sur les nervures de répartition (9) et est transportée, par l'intermédiaire de celles-ci, vers les emplacements à rendre étanchéifes.

**FIG 1**

**FIG 2**

FIG 3

FIG 4